(19) **Europäisches Patentamt / European Patent Office / Office européen des brevets**

(11) **EP 4 692 195 A1**

(12) ## EUROPEAN PATENT APPLICATION

(43) Date of publication:
**11.02.2026 Bulletin 2026/07**

(21) Application number: **24193560.0**

(22) Date of filing: **08.08.2024**

(51) International Patent Classification (IPC):
**C08K 3/013** [(2018.01)]  **C08L 23/0892** [(2025.01)]
**C08L 23/0869** [(2025.01)]  **H10F 19/80** [(2025.01)]

(52) Cooperative Patent Classification (CPC):
(C-Sets available)
**C08K 3/013; H10F 19/804**  (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Borealis GmbH**
**1020 Vienna (AT)**

(72) Inventors:
• **ODERKERK, Jeroen**
 **44486 Stenungsund (SE)**

• **ROMANENKO, Yuliia**
 **4021 Linz (AT)**
• **AARNIO-WINTERHOF, Minna Kaarina**
 **4021 Linz (AT)**
• **COSTA, Francis Reny**
 **4021 Linz (AT)**
• **GLOGER, Dietrich**
 **4021 Linz (AT)**
• **YALALOV, Denis**
 **444 86 Stenungsund (SE)**

(74) Representative: **Maiwald GmbH**
**Elisenhof**
**Elisenstraße 3**
**80335 München (DE)**

(54) ## LIGHTSHIFTING POLYMER COMPOSITIONS SUITABLE FOR PHOTOVOLTAIC MODULE APPLICATIONS

(57)    A polymer composition (PC) comprising:

a) an ethylene copolymer (PE) comprising monomer units of ethylene and one or more polar comonomer units selected from the group consisting of $(C_1-C_6)$-alkyl acrylate and $(C_1-C_6)$-alkyl $(C_1-C_6)$-alkylacrylate comonomer units, said ethylene copolymer (PE) additionally bearing silane units; and

b) one or more inorganic pigments (P) having a maximum emission peak wavelength ($\lambda_{max}$(em)) in the range from 500 to 700 nm and a maximum excitation peak wavelength ($\lambda_{max}$(exc)) outside of the range from 500 to 700 nm.

EP 4 692 195 A1

(52) Cooperative Patent Classification (CPC): (Cont.)

C-Sets
**C08F 210/02, C08F 220/14, C08F 230/085;**
**C08K 3/013, C08L 23/0869;**
**C08K 3/013, C08L 23/0892;**
C08F 210/02, C08F 220/14, C08F 230/085,
C08F 2500/12, C08F 2500/34, C08F 2500/36

**Description**

**Field of the Invention**

The present invention is directed to a polymer composition comprising a specific ethylene copolymer comprising acrylate-based comonomers and bearing silane units and to a photovoltaic module wherein the polymer composition is present as an encapsulation layer.

**Background to the Invention**

Photovoltaic modules convert sunlight into electrical power. As such, in everyday use, photovoltaic modules are exposed to sunlight near constantly throughout the day. The UV stability of such photovoltaic modules is thus a critical parameter, especially if solar power generation is to prove a cost-effective replacement to alternative methods of generating electricity, not to mention that degraded photovoltaic modules may create a waste/disposal problem in the future. The issue of UV stability is particularly relevant for newer generations of PV modules that employ new photovoltaic elements such as perovskite cells that have notoriously poor UV stability.

Organic UV stabilizers have long been used to protect polymer compositions from UV-damage, in particular in the context of photovoltaic modules. Whilst great strides have been made at providing long lasting UV protection, organic UV stabilizers inevitably decompose, which limits the lifetime of the photovoltaic modules.

Whilst inorganic pigments, such as titanium dioxide, are known to offer UV protection, such pigments must not be added in too high an amount to any layer through which light will have to pass, i.e. the front side of monofacial photovoltaic modules or either side of bifacial photovoltaic modules.

The use of lightshifting pigments, which absorb light at one wavelength and re-emit the light at another wavelength in photovoltaic modules is one way of combining UV protection with increased power output from the photovoltaic module. Whilst this general concept is not new, attempts to implement the concept have typically required complex multilayer encapsulant systems (e.g. EP 3 066 695 and EP 2 850 664) or a complex combination of lightshifting pigments with further UV stabilization (e.g. EP 2 671 263). Furthermore, the choice of polymer can often be problematic, with conventional encapsulant materials typically exhibiting poor compatibility with many lightshifting pigments, often due to poor dispersibility or reactions between the lightshifting pigments and the polymer or decomposition products of the polymer.

As such, there is a desire for simpler systems that avoid the complexities of previous solutions, as well as the drawbacks regarding dispersion and component compatiblites.

**Summary of the Invention**

The present invention is based on the finding that certain acrylate-based ethylene copolymers may help to disperse and stabilizer lightshifting pigments that may increase the UV stability and power output of photovoltaic modules.

In a first aspect, the present invention is directed to a polymer composition (PC) comprising:

a) an ethylene copolymer (PE) comprising monomer units of ethylene and one or more polar comonomer units selected from the group consisting of $(C_1-C_6)$-alkyl acrylate and $(C_1-C_6)$-alkyl $(C_1-C_6)$-alkylacrylate comonomer units, said ethylene copolymer (PE) additionally bearing silane units; and
b) one or more inorganic pigments (P) having a maximum emission peak wavelength ($\lambda_{max}$(em)) in the range from 500 to 700 nm and a maximum excitation peak wavelength ($\lambda_{max}$(exc)) outside of the range from 500 to 700 nm.

In a second aspect, the present invention is directed to a photovoltaic (PV) module, comprising, in the given order, a protective front layer element (1), a front encapsulation layer element (2), a photovoltaic element (3), a rear encapsulation layer element (4) and a protective back layer element (5), wherein the front encapsulation layer element (2) and/or the rear encapsulation layer element (4) comprise at least 90 wt.-% of the polymer composition (PC) of the first aspect.

**Definitions**

Unless defined otherwise, all technical and scientific terms used herein have the same meaning as commonly understood by one of ordinary skill in the art to which the invention pertains. Although, any methods and materials similar or equivalent to those described herein can be used in practice for testing of the present invention, the preferred materials and methods are described herein. In describing and claiming the present invention, the following terminology will be used in accordance with the definitions set out below.

Unless clearly indicated otherwise, use of the terms "a," "an," and the like refers to one or more.

In the following, amounts are given in % by weight (wt.-%) unless it is stated otherwise.

With the exception of the excitation and emission wavelength parameters, all parameters use the typical rounding convention, in other words a value of 90.0 wt.-% would hypothetically cover values as low as 89.95 wt.-% and as high as 90.04 wt.-%.

The wavelength parameters are specified to the nearest 1 nm, irrespective of the number of significant figures in the range, in other words, a range of 500 to 700 nm would not cover values as low as 450 and as high as 749 nm, but rather covers from 499.5 to 700.4 nm.

A bifacial photovoltaic module is a photovoltaic module that produces solar power from the front and the rear side of the solar cells of the photovoltaic element.

An ethylene copolymer contains at least 50 wt.-% of ethylene monomers.

The present invention will now be described in more detail.

## Detailed Description

In a first aspect, the present invention is directed to a polymer composition (PC) comprising:

> a) an ethylene copolymer (PE), and
> b) one or more inorganic pigments (P).

## The ethylene copolymer (PE)

One essential component of the polymer composition (PC) is the ethylene copolymer (PE).

The ethylene copolymer (PE) comprises monomer units of ethylene and one or more polar comonomer units selected from the group consisting of $(C_1-C_6)$-alkyl acrylate and $(C_1-C_6)$-alkyl $(C_1-C_6)$-alkylacrylate comonomer units. Furthermore, the ethylene copolymer (PE) additionally bears silane units.

It is particularly preferred that the ethylene copolymer (PE) consists of the ethylene monomer units, the one or more polar comonomer units selected from the group consisting of $(C_1-C_6)$-alkyl acrylate and $(C_1-C_6)$-alkyl $(C_1-C_6)$-alkylacrylate comonomer units and the silane units.

The silane units are preferably present as silane-containing comonomer units or as compounds grafted chemically to the ethylene copolymer (PE).

In the case that the silane groups are present as silane containing comonomer units, the silane containing comonomer units are copolymerized as a comonomer with the ethylene monomer units and the polar comonomer units during the polymerization process of the ethylene copolymer (PE). In case the silane units are incorporated to the polymer by grafting, the silane units are reacted chemically (also called as grafting), with the ethylene copolymer (PE) after the polymerization of the ethylene copolymer (PE). The chemical reaction, i.e. grafting, is performed typically using a radical forming agent such as peroxide. Such chemical reaction may take place before or during the lamination process of the invention. In general, copolymerization and grafting of the silane units to ethylene are well known techniques and well documented in the polymer field and within the skills of a skilled person.

"Silane containing comonomer" means herein above, below or in claims that the silane units are present as a comonomer. The generally acknowledged techniques of copolymerization of ethylene monomer with silane-containing comonomer is further described later under general description for polymerization process using high pressure and radical initiator and also under experimental part for describing the polymerization of ethylene copolymer (PE). As further reference for such copolymerization process, e.g. patent document, US 4,413,066 can be mentioned.

As to generally acknowledged techniques of grafting the silane units to the backbone of an ethylene polymer, for instance Sioplas and Monosil process can be mentioned. Sioplas process is described e.g. in US 3,646,155 and Monosil process is described e.g. in US 4,117,195. As further examples describing grafting techniques, e.g. WO 2009/056407, US 3,646,155 and US 4,117,195 can be mentioned.

The general copolymerization and grafting processes are also described in Polymeric Materials Encyclopedia, Vol. 2, CRC Press, 1996 (ISBN 0-8493-2470-X), p. 1552 - 1565.

It is also well known that the use of peroxide in the grafting embodiment decreases the melt flow rate (MFR) of an ethylene polymer due to a simultaneous crosslinking reaction. As a result, the grafting embodiment can bring limitation to the choice of the MFR of ethylene copolymer (PE) as a starting polymer, which choice of MFR can have an adverse impact on the quality of the polymer at the end use application. Furthermore, the by-products formed from peroxide during the grafting process can have an adverse impact on use life of the polymer composition at end use application.

The copolymerization of the silane containing comonomer into the polymer backbone provides more uniform incorporation of the units compared to grafting of the units. Moreover, compared to grafting, the copolymerization does not require the addition of peroxide after the polymer is produced.

Thus preferably, the silane units are preferably present in ethylene copolymer (PE) as a comonomer. i.e. the silane units are copolymerized as a comonomer together with the polar comonomer and ethylene monomer during the polymerization process of ethylene copolymer (PE).

The ethylene copolymer (PE) may be commercially available or can be prepared according to, or analogously to, known polymerization processes reported in the chemical literature.

The polymerization process of ethylene copolymer (PE) is preferably a high pressure polymerization process using free radical polymerization in the presence of one or more initiator(s) and optionally using a chain transfer agent (CTA) to control the MFR of the polymer.

A suitable high pressure (HP) process with suitable polymerization conditions is described in WO 2018/141672.

Such HP polymerization results in a so called low density polymer of ethylene (LDPE), herein to ethylene copolymer (PE). The term LDPE has a well-known meaning in the polymer field and describes the nature of polyethylene produced in HP, i.e. the typical features, such as different branching architecture, to distinguish the LDPE from PE produced in the presence of an olefin polymerization catalyst (also known as a coordination catalyst). Although the term LDPE is an abbreviation for low density polyethylene, the term is understood not to limit the density range, but covers the LDPE-like HP polyethylenes with low, medium and higher densities.

The silane units or, preferably, the silane containing comonomers, of ethylene copolymer (PE), are preferably hydrolysable unsaturated silane compounds represented by the formula (I):

$$R^1 SiR^2_q Y_{3-q} \qquad (I)$$

wherein

$R^1$ is an ethylenically unsaturated hydrocarbyl, hydrocarbyloxy or (meth)acryloxy hydrocarbyl group,
each $R^2$ is independently an aliphatic saturated hydrocarbyl group,
Y which may be the same or different, is a hydrolysable organic group and
q is 0, 1 or 2.

Further suitable silane units or silane-containing comonomer include e.g. gamma-(meth)acryl-oxypropyl trimethoxysilane, gamma(meth)acryloxypropyl triethoxysilane, and vinyl triacetoxy silane, or combinations of two or more thereof.

One suitable subgroup of compound of formula (I) is an unsaturated silane compound or, preferably, comonomer of formula (II)

$$CH_2=CHSi(OR)_3 \qquad (II)$$

wherein each R is independently a hydrocarbyl group having 1-8 carbon atoms, suitably 1-4 carbon atoms.

The silane units, or preferably, the silane comonomers, of the invention, are preferably selected from the group consisting of vinyl trimethoxysilane, vinyl bismethoxyethoxysilane, vinyl triethoxysilane, and combinations thereof, from the group consisting of vinyl trimethoxysilane, vinyl triethoxysilane, and combinations thereof, most preferably vinyl from the group consisting of trimethoxysilane.

It is preferred the one or more polar comonomer units are selected from the group consisting of $(C_1-C_6)$-alkyl acrylate comonomer units, more preferably from the group consisting of methyl acrylate (MA), ethyl acrylate (EA) or butyl acrylate (BA) comonomer units, most preferably the polar comonomer units are methyl acrylate comonomer units.

It is most preferred that the ethylene copolymer (PE) is a copolymer of ethylene with methyl acrylate, ethyl acrylate or butyl acrylate comonomer units and with silane comonomer units selected from the group consisting of vinyl trimethoxysilane, vinyl bismethoxyethoxysilane, vinyl triethoxysilane, vinyl trimethoxysilane, and combinations thereof, more preferably from the group consisting of vinyl trimethoxysilane, vinyl triethoxysilane, and combinations thereof. More preferably the ethylene copolymer (PE) is a copolymer of ethylene with methyl acrylate comonomer units and with silane comonomer units selected from the group consisting of vinyl trimethoxysilane, vinyl bismethoxyethoxysilane, vinyl triethoxysilane, vinyl trimethoxysilane, and combinations thereof, still more preferably a copolymer of ethylene with methyl acrylate comonomer units and with silane comonomer units selected from the group consisting of vinyl trimethoxysilane, vinyl triethoxysilane, and combinations thereof, most preferably a terpolymer of ethylene, methyl acrylate (MA), and vinyltrimethoxysilane (VTMS).

It is preferred that the ethylene copolymer (PE) has a content of silane units, determined according to quantitative $^1$H-NMR spectroscopic analysis, in the range from 1.0 to 5.0 wt.- %, more preferably in the range from 1.1 to 1.8 wt.-%, most preferably in the range from 1.2 to 1.6 wt.-%.

It is preferred that the ethylene copolymer (PE) has a content of silane units, determined according to quantitative $^1$H-NMR spectroscopic analysis, in the range from 0.05 to 2.0 mol- %, more preferably from 0.10 to 1.0 mol-%, most preferably from 0.20 to 0.50 mol-%.

It is preferred that the ethylene copolymer (PE) has a polar comonomer content, determined according to quantitative $^1$H-NMR spectroscopic analysis, in the range from 15.0 to 30.0 wt.- %, more preferably in the range from 18.0 to 27.0 wt.-%, most preferably in the range from 20.0 to 25.0 wt.-%.

It is preferred that the ethylene copolymer (PE) has a polar comonomer content, determined according to quantitative $^1$H-NMR spectroscopic analysis, in the range from 5 to 12 mol-%, more preferably from 6 to 11 mol-%, most preferably from 7 to 10 mol-%.

It is preferred that the ethylene copolymer (PE) has a density, determined according to ISO 1183-187, in the range from 920 to 960 $kg/m^3$, more preferably 930 to 955 $kg/m^3$, most preferably 940 to 950 $kg/m^3$.

It is preferred that the ethylene copolymer (PE) has a melt flow rate ($MFR_2$), determined according to ISO 1133 at 190 °C and 2.16 kg, in the range from 1.0 to 10.0 g/10 min, more preferably in the range from 2.0 to 7.0 g/10 min, most preferably in the range from 3.0 to 5.0 g/10 min.

It is preferred that the ethylene copolymer (PE) has a melting temperature ($T_m$), determined according to ISO 11357/part3/method C2, in the range from 85 to 115 °C, more preferably in the range from 87 to 100 °C, most preferably in the range from 90 to 95 °C.

The ethylene copolymer (PE) is preferably present in an amount of at least 90 wt.-%, more preferably at least 95 wt.-%, most preferably at least 98 wt.-%, relative to the total weight of the polymer composition.

**The one or more inorganic pigments (P)**

Another essential component of the polymer composition (PC) is the one of more inorganic pigments (P).

Each of the one of more inorganic pigments (P) has a maximum emission peak wavelength ($\lambda_{max}(em)$) in the range from 500 to 700 nm, more preferably in the range from 550 to 690 nm, most preferably in the range from 600 to 680 nm.

Each of the one of more inorganic pigments (P) has a maximum excitation peak wavelength ($\lambda_{max}(exc)$) outside the range from 500 to 700 nm.

In other words, the one of more inorganic pigments (P) are able to convert non-visible light (e.g. UV light or IR light) to visible light.

In one embodiment, at least one of the one or more inorganic pigments (P) has a maximum emission peak wavelength ($\lambda_{max}(em)$) in the range from 500 to 700 nm and a maximum excitation peak wavelength ($\lambda_{max}(exc)$) in the range from above 700 to 1500 nm.

Such lightshifting pigments are termed upshifting pigments, since the frequency of the light emitted is higher than that of the light absorbed. Such pigments typically convert more than one incoming photon into one outgoing photon. Such pigments are well-known in the art, with details available in Chem. Soc. Rev., 2013, 42, p. 173-201, and Angew. Chem. Int. Ed., 2011, 50(26), p. 5808-5829.

In this embodiment, the at least one pigment has a maximum emission peak wavelength ($\lambda_{max}(em)$) in the range from 500 to 700 nm, more preferably in the range from 550 to 690 nm, most preferably in the range from 600 to 680 nm. The at least one pigment has a maximum excitation peak wavelength ($\lambda_{max}(exc)$) in the range from above 700 to 1500 nm, more preferably in the range from 720 to 1200 nm, more preferably in the range from 740 to 900 nm.

Additionally or alternatively, at least one of the one or more inorganic pigments (P) has a maximum emission peak wavelength ($\lambda_{max}(em)$) in the range from 500 to 700 nm and a maximum excitation peak wavelength ($\lambda_{max}(exc)$) in the range from 200 to below 500 nm.

Such lightshifting pigments are termed downshifting pigments, since the frequency of the light emitted is lower than that of the light absorbed. Such pigments typically convert one incoming photon into one outgoing photon. Such pigments are well-known in the art, with details available in Chem. Soc. Rev., 2013, 42, p. 173-201, and Sol. Energy Mater. Sol. Cells, 2009, 93(8), p. 1182-1994.

In this embodiment, the at least one pigment has a maximum emission peak wavelength ($\lambda_{max}(em)$) in the range from 500 to 700 nm, more preferably in the range from 550 to 690 nm, most preferably in the range from 600 to 680 nm. The at least one pigment has a maximum excitation peak wavelength ($\lambda_{max}(exc)$) in the range from 200 to below 500 nm, more preferably in the range from 300 to 490 nm, more preferably in the range from 350 to 480 nm.

The one or more inorganic pigments may contain only downshifting pigments, only upshifting pigments or a mixture of upshifting and downshifting pigments.

The one or more inorganic pigments (P) are preferably present in an amount in the range from 50 to 2000 ppm, more preferably in the range from 100 to 1000 ppm, most preferably in the range from 200 to 700 ppm, relative to the total weight of the polymer composition (PC).

**The polymer composition (PC)**

The polymer composition (PC) comprises:

a) an ethylene copolymer (PE), and
b) one or more inorganic pigments (P).

In addition to the ethylene copolymer (PE) and the one or more inorganic pigments (P), the polymer composition may comprise further polymers and/or conventional additives (A).

Typically, the amounts of these further polymers and conventional additives (A) do not exceed 10 wt.-%, more preferably do not exceed 5 wt.-%, most preferably do not exceed 2 wt.-%.

The further polymers may be any conventional polymer typically used in encapsulation layers, including various ethylene containing polymers, such as ethylene methyl acrylate copolymers.

The selection of suitable additives for the polymer composition (PC) is within the general knowledge of the person skilled in the art.

For example, the one or more further additives (A) may be selected from the group consisting of antioxidants, stabilizers, fillers, nucleating agents, and antistatic agents.

Such additives are generally commercially available and are described, for example, in "Plastic Additives Handbook", pages 871 to 873, 5th edition, 2001 of Hans Zweifel.

It is particularly preferred that the polymer composition is free from organic UV stabilizers.

Not only are such UV stabilizers rendered obsolete by the stabilization provided by downshifting pigments, but they can reduce the amount of UV light that is converted into visible light, reducing the effect of boosting visible light for photovoltaic modules.

The polymer composition (PC) comprises, more preferably consists of:

a) from 90.0 to 99.995 wt.-%, more preferably from 95.0 to 99.99 wt.-%, most preferably from 98.0 to 99.98 wt.-%, relative to the total weight of the polymer composition (PC), of the ethylene copolymer (PE),
b) from 50 to 2000 ppm, more preferably in the range from 100 to 1000 ppm, most preferably in the range from 200 to 700 ppm, relative to the total weight of the polymer composition (PC), of the one or more inorganic pigments (P), and
c) optionally, from 0.0 to 10.0 wt.-%, more preferably from 0.0 to 5.0 wt.-%, most preferably from 0.0 to 2.0 wt.-%, relative to the total weight of the polymer composition (PC), of further polymers and/or conventional additives (A),

wherein the combined totals of the ethylene copolymer (PE), the one or more inorganic pigments (P) and the optional further polymers and/or conventional additives (A) do not exceed 100.0 wt.-%.

In one embodiment, the polymer composition (PC) comprises, more preferably consists of:

a) from 90.0 to 99.995 wt.-%, relative to the total weight of the polymer composition (PC), of the ethylene copolymer (PE),
b) from 50 to 2000 ppm, relative to the total weight of the polymer composition (PC), of the one or more inorganic pigments (P), and
c) optionally, from 0.0 to 10.0 wt.-%, relative to the total weight of the polymer composition (PC), of further polymers and/or conventional additives (A),

wherein the combined totals of the ethylene copolymer (PE), the one or more inorganic pigments (P) and the optional further polymers and/or conventional additives (A) do not exceed 100.0 wt.-%.

The polymer composition (PC) comprises, more preferably consists of:

a) 95.0 to 99.990 wt.-%, relative to the total weight of the polymer composition (PC), of the ethylene copolymer (PE),
b) from 100 to 1000 ppm, relative to the total weight of the polymer composition (PC), of the one or more inorganic pigments (P), and
c) optionally, from 0.0 to 5.0 wt.-%, relative to the total weight of the polymer composition (PC), of further polymers and/or conventional additives (A),

wherein the combined totals of the ethylene copolymer (PE), the one or more inorganic pigments (P) and the optional further polymers and/or conventional additives (A) do not exceed 100.0 wt.-%.

The polymer composition (PC) comprises, more preferably consists of:

a) from 98.0 to 99.980 wt.-%, relative to the total weight of the polymer composition (PC), of the ethylene copolymer (PE),
b) from 200 to 700 ppm, relative to the total weight of the polymer composition (PC), of the one or more inorganic pigments (P), and
c) optionally, from 0.0 to 2.0 wt.-% relative to the total weight of the polymer composition (PC), of further polymers and/or conventional additives (A),

wherein the combined totals of the ethylene copolymer (PE), the one or more inorganic pigments (P) and the optional further polymers and/or conventional additives (A) do not exceed 100.0 wt.-%.

**Photovoltaic (PV) module**

In a second aspect, the present invention is directed to a photovoltaic (PV) module, comprising, in the given order, a protective front layer element (1), a front encapsulation layer element (2), a photovoltaic element (3), a rear encapsulation layer element (4) and a protective back layer element (5), wherein the front encapsulation layer element (2) and/or the rear encapsulation layer element (4) comprise at least 90 wt.-% of the polymer composition (PC) of the first aspect.

Preferably the front encapsulation layer element (2) and/or the rear encapsulation layer element (4) comprise at least 95 wt.-%, yet more preferably at least 98 wt.-%, of the polymer composition (PC) of the first aspect.

In one particularly preferred embodiment, the front encapsulation layer element (2) and/or the rear encapsulation layer element (4) consist of the polymer composition (PC) of the first aspect.

More preferably the front encapsulation layer element (2) and the rear encapsulation layer element (4) comprise at least 95 wt.-%, yet more preferably at least 98 wt.-%, of the polymer composition (PC) of the first aspect.

In one particularly preferred embodiment, the front encapsulation layer element (2) and the rear encapsulation layer element (4) consist of the polymer composition (PC) of the first aspect.

It is particularly preferred that whichever of the front encapsulation layer element (2) and/or rear encapsulation layer element (4) comprises at least 90 wt.-% of the polymer composition (PC) is a monolayer encapsulation layer element.

The present invention encompasses both monofacial (light enters from only the front side) and bifacial (light enters from both the front and rear sides) photovoltaic module, therefore the protective back layer element may be opaque or transparent.

Preferably the photovoltaic module is a bifacial photovoltaic module, wherein the protective back layer element has a total luminous transmittance, determined according to ASTM D1003, in the range from 75 to 95%, more preferably in the range from 77 to 90%, most preferably in the range from 79 to 87%.

The materials of the above elements other than the front encapsulation layer element (2) and/or rear encapsulation layer element (4) are well known in the prior art and can be chosen by a skilled person depending on the desired PV module.

As is well known, the elements and the layer structure of the photovoltaic module of the invention can vary depending on the desired type of the PV module. The photovoltaic module can be rigid or flexible. The rigid photovoltaic module can for example contain a rigid or flexible protective front layer element (1), such as a rigid glass layer element or a flexible polymeric layer element, a typically flexible front encapsulation layer element (2), a photovoltaic layer element (3), a typically flexible rear encapsulation layer element (4) and a protective back layer element (5) which can be rigid or flexible. In flexible modules all the above elements are flexible, whereby the protective front and back as well as the front and rear encapsulation layer elements are typically based on polymeric layer elements.

Moreover, any of the above layer elements of the PV module can be a monolayer element or a multilayer element.

In some embodiments there can be an adhesive layer between the different layer elements of the photovoltaic (PV) module, and/or between the layers of a multilayer element of layer element(s), as well known in the art. Such adhesive layers have the function to improve the adhesion between the two elements and have a well-known meaning in the lamination field. The adhesive layers are differentiated from the other functional layer elements of the photovoltaic (PV) module, e.g. those as specified above, below or in claims, as evident for a skilled person in the art. Preferably, there is no adhesive layer between the any of the layers (1) to (5).

The protective back layer element (5) preferably comprises one or more polypropylenes, more preferably one or more heterophasic propylene-ethylene copolymers. Especially preferred protective back layer elements (5) are described in PCT/EP2024/061463, PCT/EP2024/061465, PCT/EP2024/066186, PCT/EP2024/066187, and EP 23 198 802.3.

The "photovoltaic element" means that the element has photovoltaic activity. The photovoltaic element can be e.g. an element of photovoltaic cell(s), which has a well-known meaning in the art. Silicon based material, e.g. crystalline silicon, is a non-limiting example of materials used in photovoltaic cell(s). Crystalline silicon material can vary with respect to crystallinity and crystal size, as well known to a skilled person. Alternatively, the photovoltaic element can be a substrate layer on one surface of which a further layer or deposit with photovoltaic activity is subjected, for example a glass layer, wherein on one side thereof an ink material with photovoltaic activity is printed, or a substrate layer on one side thereof a material with photovoltaic activity is deposited. For instance, in well-known thin film solutions of photovoltaic elements e.g. an ink with photovoltaic activity is printed on one side of a substrate, which is typically a glass substrate.

The photovoltaic element is most preferably an element of photovoltaic cell(s). "Photovoltaic cell(s)" means herein a layer element(s) of photovoltaic cells, as explained above, together with connectors.

All preferred embodiments and fallback positions for the polymer composition (PC) of the first aspect apply mutatis mutandis to the polymer composition (PC) of the second aspect.

## EXAMPLES

### 1. Determination methods

The following definitions of terms and determination methods apply for the above general description of the invention including the claims as well as to the below examples unless otherwise defined.

### Comonomer content of E/MA/TMS terpolymers

The methyl acrylate, vinyltrimethoxysilane, and butyl acrylate comonomer contents were determined as described in WO 2018/171951 A1 for the comonomer content quantification of the polar comonomer present in the ethylene copolymer (PE) and the content (wt.-% and mol-%) of silane group(s) containing units (preferably comonomer) present in the ethylene copolymer (PE).

### Melt Flow Rate

The melt flow rate (MFR) was determined according to ISO 1133 and was indicated in g/10 min. The MFR is an indication of the flowability, and hence the processability, of the polymer. The higher the melt flow rate, the lower the viscosity of the polymer. The $MFR_2$ of polyethylene is measured at a temperature 190 °C and a load of 2.16 kg.

### Density

The density is measured according to ISO 1183-187. Sample preparation is done by compression moulding in accordance with ISO 1872-2:2007.

**DSC analysis, melting temperature ($T_m$) and heat of fusion ($H_f$), crystallization temperature ($T_c$) and heat of crystallization ($H_c$):** measured with a TA Instrument Q200 differential scanning calorimetry (DSC) on 5 to 7 mg samples. DSC is run according to ISO 11357 / part 3 /method C2 in a heat / cool / heat cycle with a scan rate of 10 °C/min in the temperature range of -30 to +225 °C. Crystallization temperature ($T_c$) and crystallization enthalpy ($H_c$) are determined from the cooling step, while melting temperature ($T_m$) and melting enthalpy ($H_m$) are determined from the second heating step.

### Excitation (exc) and emission (em) measurements

The measurements of excitation and emission spectra have been performed using Spectrofluorometer FS5 from Edinburgh instruments equipped with 150 W CW Ozone-free xenon arc lamp, Czerny-Turner type monochromators with dual grating turret and UV enhanced silicon photodiode as reference and transmission detector. The spectra were measured from 2 mm thickness layer of a pure material under 45° reflection or using an integrating sphere. $BaSO_4$ has been used as a reference for the device calibration. For emission measurements the spectrum is typically recorded from 380 to 700 nm. In case of SSL-625 the emission spectrum was recorder in the range 390-780 nm to cut off a remaining part of excitation light. For excitation the spectra have been recorded from 250 till 525 nm for SSI-658 and from 250 nm till 425 nm for SSL-625.

### Method for particle size d10, d50, d90

Particles size distribution was analyzed according to ISO 13319 using the Multisizer 3 from Beckman Coulter.

### UV aging

UV aging was carried out according to IEC 62788-2-2, method A, conditions A5. Specimens are mounted in metal frames such that the surface faces a xenon arc and are rotated around the irradiation source. The rotation and the air-flow is put such that the defined reference black panel (defined black surface with enhanced heat dissipation by metal back surface) is at a defined temperature.

<u>A5 conditions:</u>

Irradiation energy :

81 W/m$^2$ (300-400nm)
0.8 W/m$^3$ (340 nm)
Black Panel Temperature: 110 °C
Chamber Temperature (air temperature): 85°C
Relative Humidity: 20%
Filter: Quartz (daylight)

The irradiation of the xenon arc is filtered by a quartz glass filter (Atlas quartz glass daylight filter) as to accurately reflect spectral power distribution of sunlight especially in the ultraviolet region of radiation. The humidity of the environment is defined. Conditioning is performed for a defined time interval without any testing.

**Optical properties**

The total luminous transmittance and haze were measured according to ASTM D1003-21 (Method A-Hazemeter). The diffuse luminous transmission is calculated according the formula:

$$T_d = Haze * T_t / 100,$$

where T$_t$- the total transmittance.

The clarity is measured using the same device. Clarity is evaluated at an angle of less than 2.5° from normal. For clarity measurements, the specimens are positioned at the "clarity-port". The measurement was performed as follows:

- Device: Haze gard plus
- Manufacturer: BYK-Gardner GmbH
- Type:4725
- CIE Standard Illuminant C

Conditions:

- Conditioning time: > 96 h
- Temperature: 23 °C

**Yellowness index**

The yellowness index was measured with a Spectrophotometer (Datacolor DC500) according to ASTM E313. A standardized light source lighted the colour target, and the reflection is measured at an angle of 8°. The reflected light is split into three equal parts by a beam splitter and transmitted to the three standardized colour-measuring filters X, Y and Z.

Spectrophotometers settings:

| | |
|---|---|
| **Geometry** | Diffuse 8° |
| **Observer** | 10 |
| **Illuminant** | D65 |
| **Specular gloss** | included |
| **Aperture** | SAV (9mm) |
| **UV-filter** | 100 % UV (filter off) |
| **Glass compensation** | no |

The YI is calculated in the software based on the formula:

$$YI_{E313} = \frac{100\,x\,(C_x X - C_z Z)}{Y}$$

Where C$_x$ and C$_z$ are coefficients depending on the light source and observer used.

|  | C - 2° | D65 - 2° | C - 10° | D65 - 10° |
|---|---|---|---|---|
| **Cx** | 1.2769 | 1.2985 | 1.2871 | 1.3013 |
| **Cz** | 1.0592 | 1.1335 | 1.0781 | 1.1498 |

**Short circuit current (Isc) and Impedance (Impp)**

Current-voltage (IV) characteristics of the 1-cell glass-backsheet modules were obtained using a ENDEAS QuickSun 130E flash tester. Prior to the measurements, the system was calibrated using a reference cell with known IV response. The 1-cell modules were flashed using a 60 ms light pulse from a xenon source. All results from the IV-measurements were automatically converted to standard test conditions (STC) at 25°C by the software of the supplier. Every sample setup was flashed three times, on both the glass side and the backsheet side of the module, and given IV parameters are calculated average values of these three individual measurements. All modules were flash tested with a black mask.

The black mask was made out of standard black coloured paper and had a square-shaped opening of 163* 163 mm. During flash test, the black mask was positioned in such way that the solar cell in the solar module was totally exposed to the flash pulse, and that there was 2 mm gap between the solar cell edges and the black mask. All IV characterisation was done in accordance with the IEC 60904 standard.

## 2. Examples

### 2.1 Production of ethylene/methyl acrylate/vinyltrimethoxysilane terpolymer (PE1)

PE1 is an ethylene/methyl acrylate/vinyltrimethoxysilane terpolymer having an $MFR_2$ (190 °C) of 3.5 g/10 min, a density of 948.2 kg/m$^3$, a methyl acrylate content of 22.5 wt.-% (8.75 mol-%), a vinyl trimethoxysilane content of 1.4 wt.-% (0.32 mol-%), and a melting temperature of 92 °C.

PE1 was produced in a commercial high pressure tubular reactor at a pressure of 2500-3000 bar and max temperature 250-350 °C using conventional peroxide initiator. Ethylene monomer, methyl acrylate (MA) polar comonomer and vinyl trimethoxysilane (VTMS) comonomer were added to the reactor system in a conventional manner. Chain transfer agent(s) (CTA) was used to regulated MFR as well known for a skilled person. The balance of properties described for PE above would enable the skilled person to suitably adjust the polymerization conditions to achieve the required balance.

### 2.2 Compounding of polymer compositions

Films of the inventive and comparative compositions were prepared according to the recipes in Table 1.

The film samples have been produced on a small-scale laboratory blown film line from company COLLIN Lab Pilot Solutions GmbH. The line consists of an extruder with a 30mm screw with an LID ratio of 30. The extruder temperature has been set at 140 °C. The extruder is followed by a die with a width of 300 mm. The die has flexible die lip with a die gap of 0.5-1.5 mm. The line was run at constant throughput of 10 kg/h and a line sped of 1.5 m/min. The end width of the film was cut to 210 mm. The film was produced with a thickness of 450 μm.

**Table 1** Recipes of Inventive and Comparative Examples

|  |  | IE1 | IE2 | IE3 | IE4 | IE5 | CE1 | CE2 |
|---|---|---|---|---|---|---|---|---|
| PE1 | [wt.-%] | 99.950 | 99.950 | 99.975 | 99.975 | 97.950 | 96.000 | 97.000 |
| PE2 | [wt.-%] | - | - | - | - | 1.840 | 1.840 | 1.920 |
| P1 | [wt.-%] | 0.050 | - | 0.025 | - | 0.050 | - | - |
| P2 | [wt.-%] | - | 0.050 | - | 0.025 | - | - | - |
| UV | [wt.-%] | - | - | - | - | 0.160 | 0.160 | 0.080 |
| MAH-PP | [wt.-%] | - | - | - | - | - | 2.000 | 1.000 |

For all compositions using P1 or P2, masterbatch compositions containing 5 wt.-% of the relevant pigment in PE1, prepared using a twin-screw extruder (Coperion ZSK18) at 200 °C, were used to prepare the inventive/comparative compositions.

For all compositions using UV, masterbatch compositions containing UV and PE2 were used to prepare the inventive/comparative compositions.

PE2    An ethylene-methyl acrylate copolymer, commercially available from Borealis AG (Austria), under the trade name OE2324.

P1    Pigment (alkaline earth silicate doped with europium and manganese (Ba,Sr,Ca,Mg)$_4$Si$_2$O$_8$:Eu,Mn, CAS No: 334976-92-0, commercially available from Litec LLL (Germany) under the trade name SSL-625)

dio = 11.2 $\mu$m; d$_{50}$=20.1 $\mu$m; d$_{90}$ =28.6 $\mu$m

$\lambda_{max}$(exc) = 390 nm, $\lambda_{max}$(em) = 625 nm

P2    Pigment (alkaline earth titanate doped with manganese ((Sr,Ca,Mg)TiO$_4$:Mn, CAS No: 210909-33-4, commercially available from Litec LLL (Germany) under the trade name SSL-MT-658)

d$_{10}$ = 2.4 $\mu$m; d$_{50}$=4.3 $\mu$m; d$_{90}$ =25.8 $\mu$m

$\lambda_{max}$(exc) = 465 nm, $\lambda_{max}$(em) = 658 nm

UV    UV stabilizer (CAS No. 191680-81-6, commercially available from BASF AG (Germany) under the trade name Flamestab NOR 116).

MAH-PP    Maleic anhydride modified linear low density polyethylene, commercially available from Westlake Polymer LLC (US) under the trade name TYMAX® GT4300.

### 2.3 Production of photovoltaic modules

Bifacial photovoltaic modules were produced wherein the films formed from the inventive/comparative compositions were used as the front and rear encapsulation layers.

The cell used was a mono crystalline bifacial cell with five bus-bars and having a dimension of 158.75 × 158.75 × 0.2 mm and with a cell efficiency of 22.6%. The cell was supplied by Lightway with a part number of 158B5M-BiFi-2260A-0220315.

All modules laminated were of type glass/encapsulant/cell with connectors/encapsulant/glass.

For the PV modules comprising the layer elements as described above as transparent backsheet elements, 300 mm × 200 mm laminates consisting of Glass/Encapsulant/Cell with connectors/Encapsulant/Glass element as described above were prepared using a Phototrade L036LAB vacuum laminator.

Glass layer, structured solar glass, supplied by InterFloat, length: 300 mm and width: 200 mm, total thickness of 3.2 mm. The same type of structured solar glass having a thickness of 3.2 mm was used for all modules.

The front protective glass element was cleaned with isopropanol before putting the first encapsulation layer element film on the solar glass. The front and back encapsulation layer element was cut. in 330x230mm - the excess material was cut off after lamination. After, the front encapsulation layer element was put on the front protective glass element, the soldered solar cell was put on the front encapsulation layer element. Further the back encapsulation layer element was put on the obtained PV cell element. The layer element of the invention was cut in 330x230mm - the excess material was cut off after lamination. Further the layer element of the invention was put on top of the back encapsulation layer element. No soldering wire was used during soldering. During soldering a soldering flux Ulbrich of Austria GmbH - 5x0,3mm (Pr.Nr.: 7746-BUS1) & Ulbrich of Austria GmbH - 1x0,2mm - (Pr.Nr.: 7746-TAB1) was used.

The obtained PV module assembly was then subjected to a lamination process as described below in Table 2.

Table 2 Lamination settings (time profile) for photovoltaic module production

|  | Step 1 ( Evacuation) | Step 2 (Pressing) |
|---|---|---|
| Temperature, °C | 150 | 150 |
| Pressure, mbar | 0 | 800 |
| Time, sec | 300 | 600 |

The vacuum lamination occurred at 150°C using a lamination program of 5 minutes evacuation time (i.e. Step 1), followed by 10 minutes pressing time with an upper chamber pressure of 800 mbar (i.e. Step 2).

### 2.4 Power output of photovoltaic modules

The effect of the lightshifting pigments on the current generating capabilities of the PV modules was evaluated by exposing said PV modules to light from either the front or the rear side, with the effect characterized as the percentage change in short circuit current (Isc), relative to the neat cell (i.e. the photovoltaic element without any protective front layer element, front encapsulation layer element, rear encapsulation layer element or protective back layer element).

**Table 3** Output of PV modules

|  | Isc | | | Impp | | |
|---|---|---|---|---|---|---|
|  | front | rear | Total (front+rear) | front | rear | Total (front+rear) |
| **IE1** | -2.07% | +7.78% | +5.71% | -1.87% | +7.75% | +5.88% |
| **IE2** | -2.88% | +7.49% | +4.61% | -2.68% | +7.48% | +4.80% |
| **IE3** | -1.77% | +7.62% | +5.85% | -1.57% | +7.64% | +6.07% |
| **IE4** | -2.54% | +8.31% | +5.77% | -2.22% | +8.34% | +6.12% |
| **IE5** | -2.63% | +6.87% | +4.24% | -2.52% | +6.75% | +4.23% |
| **CE1** | -2.78% | +7.20% | +4.42% | -2.76% | +7.17% | +4.41% |
| **CE2** | -3.18% | +6.94% | +3.76% | -3.17% | +6.85% | +3.68% |

As can be seen from the data presented in Table 3, the addition of lightshifting pigments into the front and rear encapsulation layer elements improves the overall current output, both from the front and the rear. Whilst the inventive examples represent an improvement over the comparative examples, the examples having only 250 ppm of pigment (i.e. IE3 and IE4) appear to be slightly better than those having 500 ppm of pigment (i.e. IE1 and IE2), indicating that there may be some self-quenching effects at higher pigment concentrations. Furthermore, the examples that are free from organic UV-stabilizers (IE1 to IE4) have considerably better performance than those containing UV-stabilizers (IE5), which is presumably due to the UV stabilizers reducing the amount of UV light that is converted to visible light by the lightshifting pigments.

### 2.5 Stability of photovoltaic modules

Glass/encapsulant/glass laminates were prepared by laminating the films formed from the inventive/comparative compositions between two glass plates. Glass plates, structured solar glass, supplied by InterFloat, length: 300 mm and width: 200 mm, total thickness of 3.2 mm. The lamination was performed according to conditions mentioned in Table2.
These glass/encapsulant/glass laminates containing IE1 to IE5 were exposed to UV aging as described in the determination methods, with measurements of the yellowness index and various optical properties carried out after 1000 hours and 2540 hours.
The results of said measurements are given in Table 4.

**Table 4** Stability data for PV modules

|  |  | IE1 | IE2 | IE3 | IE4 | IE5 |
|---|---|---|---|---|---|---|
| Yellowness index | 0 h | 4.7 | 4.4 | 4.5 | 4.4 | 4.3 |
|  | 1000 h | 3.9 | 3.9 | 3.9 | 4.0 | 4.0 |
|  | 2540 h | 3.9 | 3.8 | 3.8 | 3.8 | 4.2 |
| Total luminous transmittance | 0 h | 91.03 | 90.37 | 91.17 | 90.57 | 90.07 |
|  | 1000 h | 91.6 | 90.7 | 91.5 | 90.9 | 90.2 |
|  | 2540 h | 91.7 | 90.9 | 91.7 | 91.0 | 90.4 |
| Diffuse luminous transmittance | 0 h | 3.94 | 4.7 | 2.89 | 4.98 | 8.14 |
|  | 1000 h | 13.28 | 16.05 | 15.28 | 14.73 | 17.68 |
|  | 2540 h | 11.92 | 14.73 | 10.18 | 14.47 | 16.81 |
| Haze | 0 h | 4.32 | 5.21 | 3.16 | 5.5 | 9.03 |
|  | 1000 h | 14.5 | 17.7 | 16.7 | 16.2 | 19.6 |
|  | 2540 h | 13 | 16.2 | 11.1 | 14.47 | 18.6 |

(continued)

|  |  | IE1 | IE2 | IE3 | IE4 | IE5 |
|---|---|---|---|---|---|---|
|  | 0 h | 99 | 98.9 | 99.2 | 99 | 98.9 |
| Clarity | 1000 h | 94.6 | 95 | 95.6 | 95.8 | 96.6 |
|  | 2540 h | 94.5 | 95.3 | 95.2 | 94.5 | 96.7 |

As can be seen from Table 4, the examples that do not contain the organic UV stabilizers are no less stable against UV aging, despite the absence of these conventional additives. Indeed, it is the understanding of the inventors that the stability against UV aging would be considerably longer lasting for compositions containing the lightshifting pigments, relative to those containing only conventional UV stabilizers, since organic UV stabilizers are known to decompose over time, whereas the same is not true for the inorganic downshifting pigments. In this context, the choice of the polymer of the encapsulation layer is particularly important, given the basic nature of conventional lightshifting pigments. The polar comonomers and silane units of the ethylene copolymer according to the present invention help to ensure good dispersion of the inorganic pigment within the encapsulation layer without relying on acidic groups (as would be the case for conventional EVA encapsulants, which are known to decompose over time releasing acetic acid) that would degrade the inorganic pigments.

This long-lasting UV stability is particularly important for newer generations of photovoltaic cells, such as perovskite cells, which very sensitive to UV light.

**Claims**

1. A polymer composition (PC) comprising:

   a) an ethylene copolymer (PE) comprising monomer units of ethylene and one or more polar comonomer units selected from the group consisting of ($C_1$-$C_6$)-alkyl acrylate and ($C_1$-$C_6$)-alkyl ($C_1$-$C_6$)-alkylacrylate comonomer units, said ethylene copolymer (PE) additionally bearing silane units; and
   b) one or more inorganic pigments (P) having a maximum emission peak wavelength ($\lambda_{max}$(em)) in the range from 500 to 700 nm and a maximum excitation peak wavelength ($\lambda_{max}$(exc)) outside of the range from 500 to 700 nm.

2. The polymer composition (PC) according to claim 1, wherein the silane units of ethylene copolymer (PE) are present as silane-containing comonomer units.

3. The polymer composition (PC) according to claim 1 or claim 2, wherein the one or more polar comonomer units are selected from the group consisting of ($C_1$-$C_6$)-alkyl acrylate comonomer units, more preferably from the group consisting of methyl acrylate (MA), ethyl acrylate (EA) or butyl acrylate (BA) comonomer units, most preferably the polar comonomer units are methyl acrylate comonomer units.

4. The polymer composition (PC) according to any one of the preceding claims, wherein the silane units are selected from the group consisting of vinyl trimethoxysilane, vinyl bismethoxyethoxysilane, vinyl triethoxysilane, vinyl trimethoxysilane, and combinations thereof, more preferably from the group consisting of vinyl trimethoxysilane, vinyl triethoxysilane, and combinations thereof.

5. The polymer composition (PC) according to any one of the preceding claims, wherein the ethylene copolymer (PE) is a terpolymer of ethylene, methyl acrylate (MA) and vinyltrimethoxysilane (VTMS).

6. The polymer composition (PC) according to any one of the preceding claims, wherein the ethylene copolymer (PE) has a polar comonomer content, determined according to quantitative $^1$H-NMR spectroscopic analysis, in the range from 15.0 to 30.0 wt.-%, more preferably in the range from 18.0 to 27.0 wt.-%, most preferably in the range from 20.0 to 25.0 wt.-%.

7. The polymer composition (PC) according to any one of the preceding claims, wherein the ethylene copolymer (PE) has a content of silane units, determined according to quantitative $^1$H-NMR spectroscopic analysis, in the range from 1.0 to 5.0 wt.-%, more preferably in the range from 1.1 to 1.8 wt.-%, most preferably in the range from 1.2 to 1.6 wt.-%.

8. The polymer composition (PC) according to any one of the preceding claims, wherein the ethylene copolymer (PE) has one or more, preferably all, of the following properties:

a) a density, determined according to ISO 1183-187, in the range from 920 to 960 kg/m$^3$;
b) a melt flow rate (MFR$_2$), determined according to ISO 1133 at 190 °C and 2.16 kg, in the range from 1.0 to 10.0 g/10 min; and/or
c) a melting temperature (T$_m$), determined according to ISO 11357/part3/method C2, in the range from 85 to 115 °C.

9. The polymer composition (PC) according to any one of the preceding claims, being free from organic UV stabilizers.

10. The polymer composition (PC) according to any one of the preceding claims, wherein at least one of the one or more inorganic pigments (P) has a maximum emission peak wavelength ($\lambda_{max}$(em)) in the range from 500 to 700 nm and a maximum excitation peak wavelength ($\lambda_{max}$(exc)) in the range from 200 to below 500 nm.

11. The polymer composition (PC) according to any one of the preceding claims, wherein at least one of the one or more inorganic pigments (P) has a maximum emission peak wavelength ($\lambda_{max}$(em)) in the range from 500 to 700 nm and a maximum excitation peak wavelength ($\lambda_{max}$(exc)) in the range from above 700 to 1500 nm.

12. The polymer composition (PC) according to any one of the preceding claims, wherein the one or more inorganic pigments (P) is present in an amount in the range from 50 to 2000 ppm, more preferably in the range from 100 to 1000 ppm, most preferably in the range from 200 to 700 ppm, relative to the total weight of the polymer composition (PC).

13. A photovoltaic (PV) module, comprising, in the given order, a protective front layer element (1), a front encapsulation layer element (2), a photovoltaic element (3), a rear encapsulation layer element (4) and a protective back layer element (5), wherein the front encapsulation layer element (2) and/or the rear encapsulation layer element (4) comprise at least 90 wt.-% of the polymer composition (PC) according to any one of claims 1 to 12.

14. The photovoltaic (PV) module according to claim 13, wherein whichever of the front encapsulation layer element (2) and/or rear encapsulation layer element (4) comprises at least 90 wt.-% of the polymer composition (PC) is a monolayer encapsulation layer element.

Europäisches
Patentamt

European
Patent Office

Office européen
des brevets

# EUROPEAN SEARCH REPORT

**Application Number**

EP 24 19 3560

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 105 733 457 A (HANGZHOU FIRST PV MAT CO LTD) 6 July 2016 (2016-07-06) | 1,6,9-12 | INV. C08K3/013 |
| Y | * example 5 * | 2-5,7,8, | C08L23/0892 |
| Y | * claims 1-10 * | 13,14 | C08L23/0869 H10F19/80 |
| | ----- | | |
| Y | WO 2018/229191 A1 (BOREALIS AG [AT]) 20 December 2018 (2018-12-20) * example 1 * * claims 1-17 * | 2-5,7,8, 13,14 | |
| | ----- | | |
| Y | US 2023/227644 A1 (HESSELGREN JESSICA [SE] ET AL) 20 July 2023 (2023-07-20) | 2-5,7,8 | |
| A | * Comparative Example 4; example 1 * * claims 1-20 * | 1,9-14 | |
| | ----- | | |
| A | CN 101 593 783 A (BEX TECHNOLOGIES JIANGSU CO LT [CN]) 2 December 2009 (2009-12-02) * pages 10, 11 * * claims 1-14 * | 1-14 | |
| | ----- | | **TECHNICAL FIELDS SEARCHED (IPC)** |
| A | KR 2019 0053875 A (SUMITOMO CHEMICAL CO [JP]) 20 May 2019 (2019-05-20) * paragraph [273ff.] * * claims 1-13 * | 1-14 | C08K C08L H10F |
| | ----- | | |

The present search report has been drawn up for all claims

| Place of search | Date of completion of the search | Examiner |
|---|---|---|
| Munich | 20 January 2025 | Neumeier, Michael |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

    & : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 19 3560

This annex lists the patent family members relating to the patent documents cited in the above-mentioned European search report.
The members are as contained in the European Patent Office EDP file on
The European Patent Office is in no way liable for these particulars which are merely given for the purpose of information.

20-01-2025

| Patent document cited in search report | | Publication date | Patent family member(s) | | Publication date |
|---|---|---|---|---|---|
| CN 105733457 | A | 06-07-2016 | NONE | | |
| WO 2018229191 | A1 | 20-12-2018 | AU | 2018285447 A1 | 05-12-2019 |
| | | | CN | 110730803 A | 24-01-2020 |
| | | | EP | 3638722 A1 | 22-04-2020 |
| | | | JP | 2020524894 A | 20-08-2020 |
| | | | KR | 20200014348 A | 10-02-2020 |
| | | | TW | 201905063 A | 01-02-2019 |
| | | | US | 2020098941 A1 | 26-03-2020 |
| | | | WO | 2018229191 A1 | 20-12-2018 |
| US 2023227644 | A1 | 20-07-2023 | CN | 115720550 A | 28-02-2023 |
| | | | EP | 4171953 A1 | 03-05-2023 |
| | | | US | 2023227644 A1 | 20-07-2023 |
| | | | WO | 2022002666 A1 | 06-01-2022 |
| CN 101593783 | A | 02-12-2009 | NONE | | |
| KR 20190053875 | A | 20-05-2019 | CN | 109689790 A | 26-04-2019 |
| | | | JP | 2018044160 A | 22-03-2018 |
| | | | KR | 20190053875 A | 20-05-2019 |
| | | | TW | 201815899 A | 01-05-2018 |
| | | | WO | 2018047760 A1 | 15-03-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 3066695 A
- EP 2850664 A
- EP 2671263 A
- US 4413066 A
- US 3646155 A
- US 4117195 A
- WO 2009056407 A
- WO 2018141672 A
- EP 2024061463 W
- EP 2024061465 W
- EP 2024066186 W
- EP 2024066187 W
- EP 23198802 A
- WO 2018171951 A1

### Non-patent literature cited in the description

- Polymeric Materials Encyclopedia. CRC Press, 1996, vol. 2, 1552-1565
- *Chem. Soc. Rev.*, 2013, vol. 42, 173-201
- *Angew. Chem. Int. Ed*, 2011, vol. 50 (26), 5808-5829
- *Sol. Energy Mater. Sol. Cells*, 2009, vol. 93 (8), 1182-1994
- **HANS ZWEIFEL**. Plastic Additives Handbook. 2001, 871-873
- *CHEMICAL ABSTRACTS*, 191680-81-6